# EUROPEAN PATENT APPLICATION

(11) **EP 4 759 771 A1**
(43) Date of publication of application: **17.06.2026**
(21) Application number: 24942496.1
(22) Date of filing: 24.12.2024
(51) Int. Cl.: B81C 1/00, B81B 7/04, H04R 19/04, G01L 9/12

(54) **MEMS DEVICE AND MANUFACTURING METHOD THEREFOR**

(30) Priority: 03.06.2024 CN 202410712950
(71) Applicant: China Resources Microelectronics Holdings Limited, Jingan District Shanghai 200072 (CN)
(72) Inventor: ZHU, Encheng, Shanghai 200072 (CN); LI, Shaoping, Shanghai 200072 (CN); JIN, Wenchao, Shanghai 200072 (CN); ZHANG, Bing, Shanghai 200072 (CN); DONG, Yang, Shanghai 200072 (CN); GAO, Duoduo, Shanghai 200072 (CN); YAN, Kai, Shanghai 200072 (CN); YANG, Guoqing, Shanghai 200072 (CN); WANG, Jie, Shanghai 200072 (CN)
(74) Representative: HGF
(86) International application number: PCT/CN2024/141762
(87) International publication number: WO 2025/251593

(57) **Abstract**

The present application discloses a MEMS device and a manufacturing method thereof. The method includes: forming a first MEMS structure, which includes providing a first substrate, forming a first sensing layer on the first substrate, and sequentially forming a first cavity and a second sensing layer on the first sensing layer; forming a second MEMS structure, which includes providing a second substrate, forming a third sensing layer on the second substrate, and sequentially forming a second cavity and a fourth sensing layer on the third sensing layer; bonding the second sensing layer with the fourth sensing layer to form a common sensing layer; and removing a portion of the first substrate corresponding to the first cavity, such that the first sensing layer to form a deformable sensing layer.

## Description

### CROSS-REFERENCE TO RELATED APPLICATIONS

The present application claims priority to Chinese Patent Application with No. 202410712950.0, entitled "MEMS device and Manufacturing Method Therefor", and filed on June 3, 2024, the content of which is expressly incorporated herein by reference in its entirety.

### TECHNICAL FIELD

The present application relates to the field of semiconductor technologies, particularly to a MEMS device and a manufacturing method thereof.

### BACKGROUND

Micro-electro-mechanical system (MEMS) technology is a high-tech field developed at a high speed in recent years. The MEMS technology uses an advanced semiconductor manufacturing process to implement bulk manufacturing of devices such as sensors and drivers. Compared to the corresponding conventional devices, the MEMS device has obvious advantages in terms of volume, power consumption, weight, and price. In the market, the main application examples of the MEMS devices include pressure sensors, accelerometers, silicon microphones, and so on.

The existing capacitive pressure sensor mainly uses a silicon surface micromachining technology, and the structure of the sensor is prepared by using thin film deposition, photolithography, and etching processes. Most of the processing is used in a surface layer region of a wafer. A certain number of release holes are etched in the middle region of an upper electrode plate through the etching process, and then a sacrificial layer in the corresponding region is corroded through the release holes to form a movable cavity position of the upper electrode plate. Afterward, the release holes of the upper electrode plate are sealed by a hole-plugging structure to form a sealed absolute pressure cavity, which is configured to perform a pressure measurement. However, the hole-plugging process may form uneven raised structures on the surface of the flat sensitive film structure, which may introduce uncontrollable stress factors and lead to increased measurement errors of the critical sensitive film structure to due to the stress influence. In addition, the sealed chamber may experience gas leakage or other failure issues during long-term use due to reliability problems, severely affecting the device's lifespan and yield.

### SUMMARY

In the summary, a series of simplified forms of concepts are introduced, which will be further elaborated in the specific implementation modes. The summary of the present application does not imply an attempt to define key features and essential technical features of the claimed technical solution, nor does it imply an attempt to determine the protection scope of the claimed technical solution.

The present application provides a method for manufacturing a micro-electro-mechanical system (MEMS) device, including:
forming a first MEMS structure, which includes:
   providing a first substrate and forming a first sensing layer on the first substrate; and
   forming a first cavity and a second sensing layer sequentially on the first sensing layer;
forming a second MEMS structure, which includes:
   providing a second substrate, forming a third sensing layer on the second substrate and
   forming a second cavity and a fourth sensing layer sequentially on the third sensing layer;
bonding the second sensing layer with the fourth sensing layer to form a common sensing layer; and
removing a portion of the first substrate corresponding to the first cavity, and thus the first sensing layer forms a deformable sensing layer.

In some embodiments, the deformable sensing layer and the common sensing layer form a deformable capacitor, and the common sensing layer and the third sensing layer form a reference capacitor.

In some embodiments, forming the first cavity on the first sensing layer includes:
forming a first sacrificial layer and the second sensing layer sequentially on the first sensing layer;
forming a plurality of first through holes on the second sensing layer; and
removing a portion of the first sacrificial layer through the plurality of first through holes to form the first cavity.

In some embodiments, a plurality of second through holes are formed on the fourth sensing layer, the plurality of first through holes and the plurality of second through holes are in a one-to-one correspondence, and the plurality of first through holes are communicated with the plurality of second through holes respectively after the second sensing layer is bonded with the fourth sensing layer, such that the first cavity and the second cavity form a common cavity.

In some embodiments, the method further includes thinning the second substrate such that a thickness of the second substrate is within a range of 40µm to 50µm.

In some embodiments, thicknesses of the first sensing layer, the second sensing layer, the third sensing layer, and the fourth sensing layer are in a range of 1µm to 5µm, and the first sensing layer, the second sensing layer, the third sensing layer, and the fourth sensing layer include doped polysilicon layers.

In some embodiments, before removing the portion of the first substrate corresponding to the first cavity, the method further includes:
etching the first substrate to form a four-corner support structure at a bottom portion of the first substrate, where the four-corner support structure is configured to fixedly connect the MEMS device to a package substrate.

In some embodiments, the method further includes forming a metal wiring layer on the second substrate, where the metal wiring layer is connected to the third sensing layer, the common sensing layer, and the deformable sensing layer respectively.

In some embodiments, forming the plurality of first through holes on the second sensing layer includes:
forming a patterned mask layer on the second sensing layer through a photolithography process, and etching the second sensing layer to form the plurality of first through holes.

In some embodiments, forming the second cavity on the third sensing layer includes:
forming a second sacrificial layer and the fourth sensing layer sequentially on the third sensing layer, forming a plurality of second through holes on the fourth sensing layer, and removing a portion of the second sacrificial layer through the plurality of second through holes to form the second cavity.

The present application also provides a MEMS device manufactured according to any one of the above methods, the MEMS device including:
a first substrate on which a first sensing layer, a first cavity, a common sensing layer, a second cavity, a third sensing layer, and a second substrate are sequentially formed, wherein the first substrate includes an opening provided corresponding to the first cavity, such that the first sensing layer forms a deformable sensing layer.

In some embodiments, the MEMS device includes a pressure sensor, and the sensing layers include pressure sensing films.

In some embodiments, a four-corner support structure is formed at a bottom portion of the first substrate, and is configured to fixedly connect the MEMS device to a package substrate.

In some embodiments, a metal wiring layer is further formed on the second substrate, the metal wiring layer includes metal traces and is connected to the third sensing layer, the common sensing layer, and the deformable sensing layer respectively.

According to the MEMS device and the method for manufacturing the MEMS device provided in the present application, a stacked double-layer capacitor structure is manufactured in a heterogeneous bonding mode. The process is simple and highly feasible, and the manufactured device structure does not require hole plugging, which avoids the unevenness of the sensing layer caused by hole plugging. It also avoids reliability issues such as air leakage of the hole plugging structure due to the repeated movement of the upper pressure-sensitive film of the sealed cavity during pressure measurement, improving the service life and yield of the device.

### BRIEF DESCRIPTION OF THE DRAWINGS

In order to more clearly illustrate the technical solution described in the embodiments of the present application or the conventional technology, accompanying drawings required for describing the embodiments or the conventional technology are briefly introduced below. Obviously, the drawings described below are merely embodiments of the present application, and those skilled in the art can obtain other drawings based on the disclosed drawings without any creative effort.
FIG. 1 is a flow chart showing a method for manufacturing a MEMS device according to embodiments of the present application.
FIGS. 2A to 2F are schematic cross-sectional diagrams of structures sequentially obtained by performing a method for manufacturing a MEMS device according to embodiments of the present application.
FIG. 3 is a top view of a MEMS device according to embodiments of the present application.
FIG. 4 is a schematic structure diagram of an electronic device including a MEMS device according to embodiments of the present application.

### DETAILED DESCRIPTION

In the following description, a large number of specific details are provided to provide more thorough understanding of the present application. However, it is obvious to a person skilled in the art that the present application may be implemented without one or more of these details. In order to avoid confusion with the present application, some technical features well-known in the art are not described in other examples.

It should be appreciated that the present application can be implemented in different forms, and should not be construed as limited to the embodiments provided herein. Rather, these embodiments will make the disclosure thorough and complete, and the scope of the present application fully communicated to those skilled in the art. In the accompanying drawings, for clarity, dimensions and relative dimensions of layers and regions may be exaggerated. The same reference signs represent the same elements from the beginning to the end.

It should be appreciated that when an element or layer is referred to as being "on", "adjacent to", "connected to" or "coupled to" other elements or layers, the element may be directly located on, adjacent to, connected to, or coupled to other elements or layers, or there may exist an intermediate element or layer. Rather, when an element is referred to as being "directly on", "adjacent to", "directly connected to" or "directly coupled to" other elements or layers, there is no intermediate element or layer. It should be appreciated that, although the terms first, second, third and the like may be used for describing various elements, components, regions, layers and/or portions, these elements, components, regions, layers and/or portions shall not be limited by these terms. These terms are utilized only to distinguish one element, component, region, layer or portion from another element, component, region, layer or portion. Therefore, without departing from the teaching of the present application, the first element, component, region, layer, or portion discussed below may be represented as a second element, component, region, layer, or portion.

The spatial relationship terms such as "below", "under", "beneath", "above", "upper" and the like may be used herein for convenience of description, in order to describe a relationship between one element or feature and other elements or features shown in the figures. It should be appreciated that, in addition to the orientations shown in the figures, the intention of the spatial relationship terms further includes different orientations of a component in use and operations. For example, if the component in the drawing is turned over, an element or feature described as "under" or "below" or "beneath" other elements or features will be oriented to be "above" other elements or features. Therefore, the exemplary terms "under" or "below" may include two orientations: upper and lower. The component may be otherwise oriented (rotated by 90 degrees or other orientations) and the spatial relationship terms used herein are interpreted accordingly.

The terms used herein are merely intended to describe specific embodiments and are not intended to limit the present application. In use herein, the singular forms "a", "an" and "the/said" are also intended to include plural forms unless the context clearly indicates another manner. It should also be appreciated that the terms "comprising" and/or "including" mean to determine the presence of the features, integers, steps, operations, elements and/or components when used in the description, but do not exclude the presence or addition of one or more other features, integers, steps, operations, elements, components and/or groups. In use herein, the term "and/or" includes any and all combinations of the listed relevant items.

In order to fully understand the present application, detailed steps and detailed structures are proposed in the following description, to explain the technical solution provided in the present application. Some embodiments of the present application are elaborated as follows. However, in addition to these detailed descriptions, the present application may have other implementation modes.

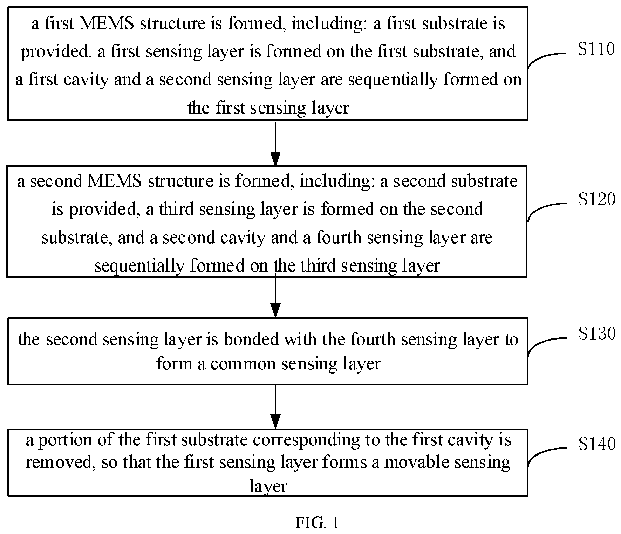

The present application provides a method for manufacturing a MEMS device. As shown in FIG. 1, the method includes the following steps S110 to S140.

Step S110: a first MEMS structure is formed, including: providing a first substrate, forming a first sensing layer on the first substrate, and forming a first cavity and a second sensing layer sequentially on the first sensing layer.

Step S 120: a second MEMS structure is formed, including: providing a second substrate, forming a third sensing layer on the second substrate, and forming a second cavity and a fourth sensing layer sequentially formed on the third sensing layer.

Step S130: the second sensing layer is bonded with the fourth sensing layer to form a common sensing layer.

Step S140: a portion of the first substrate corresponding to the first cavity is removed, so that the first sensing layer forms a deformable sensing layer.

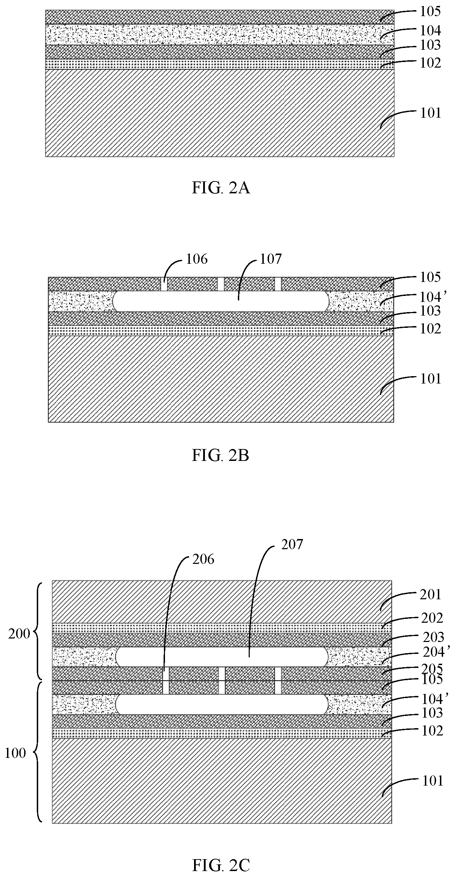

The method for manufacturing the MEMS device of the present application will be elaborated with reference to FIG. 2A to FIG. 2F which are schematic cross-sectional diagrams of structures sequentially obtained by performing the method for manufacturing the MEMS device according to the embodiments of the present application.

First, the step S110 is performed. As shown in FIG. 2A to FIG. 2B, a first MEMS structure 100 is formed, which specifically includes the following steps: a first substrate 101 is provided, a first sensing layer 103 is formed on the first substrate 101, and a first cavity 107 and a second sensing layer 105 are sequentially formed on the first sensing layer 103.

For example, the step of forming the first cavity 107 on the first sensing layer 103 includes that a first sacrificial layer 104 and a second sensing layer 105 are sequentially formed on the first sensing layer 103, a plurality of first through holes 106 are formed on the second sensing layer 105, and a portion of the first sacrificial layer 104 is removed through the plurality of first through holes 106 to form the first cavity 107.

In an embodiment, as shown in FIG. 2A, the first substrate 101 is provided. The first substrate 101 may be any appropriate semiconductor substrate, for example, a silicon substrate, or may be made of at least one of the following materials mentioned: Si, Ge, SiGe, SiC, SiGeC, InAs, GaAs, InP, or other III/V compound semiconductors, or may further include a multi-layer structure formed by these semiconductor materials, or may be Silicon on Insulator (SOI), Stacked Silicon on Insulator (SSOI), Stacked Silicon-Germanium on Insulator (S-SiGeOI), Silicon-Germanium on Insulator (SiGeOI), or Germanium on Insulator (GeOI), or may be a Double Side Polished Wafe (DSP), or may be a ceramic substrate such as alumina, a quartz substrate or a glass substrate, etc.

In an embodiment, as shown in FIG. 2A, a first insulating layer 102, the first sensing layer 103, the first sacrificial layer 104, and the second sensing layer 105 are sequentially formed on the first substrate 101. A material of the first insulating layer 102 includes but is not limited to an oxide layer. A method for forming the first insulating layer 102 may use any existing techniques known to those skilled in the art, for example, a thermal oxidation or vapor deposition method, etc. Materials of the first sensing layer 103 and the second sensing layer 105 include but are not limited to doped polysilicon, and a thickness range of the first sensing layer 103 and the second sensing layer 105 is 1um to 5um. The material of the first sacrificial layer 104 includes but is not limited to an oxide layer. A thickness of the first sacrificial layer 104 may be set as required. A spacing between the first sensing layer 103 and the second sensing layer 105 is controlled by controlling the thickness of the first sacrificial layer 104, so as to control a capacitance value between the first sensing layer 103 and the second sensing layer 105. The forming processes of the first sensing layer 103, the first sacrificial layer 104, and the second sensing layer 105 may be any existing techniques known to those skilled in the art, such as one of a Low-Pressure Chemical Vapor Deposition (LPCVD) formed by a Chemical Vapor Deposition (CVD) method, a physical vapor deposition (PVD) method or an atomic layer deposition (ALD) method, a Laser Ablation Deposition (LAD), or a Selective Epitaxial Growth (SEG), or one of a Low-Temperature Chemical Vapor Deposition (LTCVD), a Rapid Thermal Chemical Vapor Deposition (RTCVD), or a Plasma Enhanced Chemical Vapor Deposition (PECVD).

In an embodiment, as shown in FIG. 2B, a plurality of first through holes 106 are formed on the second sensing layer 105. Specifically, a patterned mask layer (not shown) is formed on the second sensing layer 105 through the photolithography process, and then the second sensing layer 105 is etched to form the plurality of first through holes 106. The method for etching the second sensing layer 105 may use any existing techniques known to those skilled in the art, and in some embodiments, a dry etching is used. The dry etching includes but is not limited to reactive ion etching (RIE), ion beam etching, plasma etching, laser ablation, or any combination thereof.

In an embodiment, the first sacrificial layer 104 is etched through the plurality of first through holes 106 to form the first cavity 107 and a first support portion 104' surrounding the first cavity. The method for etching the first sacrificial layer 104 may use any existing techniques known to those skilled in the art, and in some embodiments, wet etching is used. A wet etching solution is selective. In a case where silicon oxide is selected for the first sacrificial layer 104 and doped polysilicon is selected for the first sensing layer 103 and the second sensing layer 105, the wet etching solution may be a buffered oxide etch (BOE) solution, and the BOE solution is prepared by mixing HF, NH₄F, and deionized water.

Step S120 is performed to form a second MEMS structure 200, which specifically includes the following steps: a second substrate 201 is provided, a third sensing layer 203 is formed on the second substrate 201, a second cavity 207 and a fourth sensing layer 205 are sequentially formed on the third sensing layer 203.

For example, the step of forming the second cavity 207 on the third sensing layer 203 includes that a second sacrificial layer 204 and the fourth sensing layer 205 are sequentially formed on the third sensing layer 203, a plurality of second through holes 206 are formed on the fourth sensing layer 205, a portion of the second sacrificial layer 204 is removed through the plurality of second through holes 206 to form the second cavity 207.

For a method for forming the second MEMS structure 200, reference can be made to the method for forming the first MEMS structure 100, and the details are not repeated herein.

Step S130 is performed, as shown in FIG. 2C. The second sensing layer 105 is bonded with the fourth sensing layer 205 to form a common sensing layer.

In an embodiment, before the second sensing layer 105 is bonded with the fourth sensing layer 205, the above method may further include performing chemical mechanical polishing on the second sensing layer 105 and the fourth sensing layer 205, so that surfaces of the second sensing layer 105 and the fourth sensing layer 205 meet the bonding requirements. Subsequently, the second sensing layer 105 and the fourth sensing layer 205 are bonded to each other, to realize the bonding between the first MEMS structure 100 and the second MEMS structure 200.

In an embodiment, the plurality of first through holes 106 formed on the second sensing layer 105 and the plurality of second through holes 206 formed on the fourth sensing layer 205 are in a one-to-one correspondence. After the second sensing layer 105 is bonded with the fourth sensing layer 205, the plurality of first through holes 106 are respectively communicated with the plurality of second through holes 206, so that the first cavity 107 and the second cavity 207 form a common cavity. Since a vacuum bonding process is used for bonding the second sensing layer 105 and the fourth sensing layer 205, the common cavity formed by the first cavity 107 and the second cavity 207 keeps a vacuum state or a low-pressure state close to vacuum, for example, the air pressure in the cavity is less than 10Pa.

In an embodiment, the method may further include a step of thinning the second substrate 201. Specifically, the second substrate 201 is thinned using chemical mechanical polishing (CMP), so that a thickness of the second substrate 201 falls within a range of 40µm to 50µm. By maintaining a relatively large thickness of the second substrate 201, deformation of the third sensing layer 203 is avoided, and a non-deformation state of the second cavity 207 is ensured. The third sensing layer 203 and the common sensing layer form a fixed capacitor that does not change with pressure, which serves as a reference capacitor.

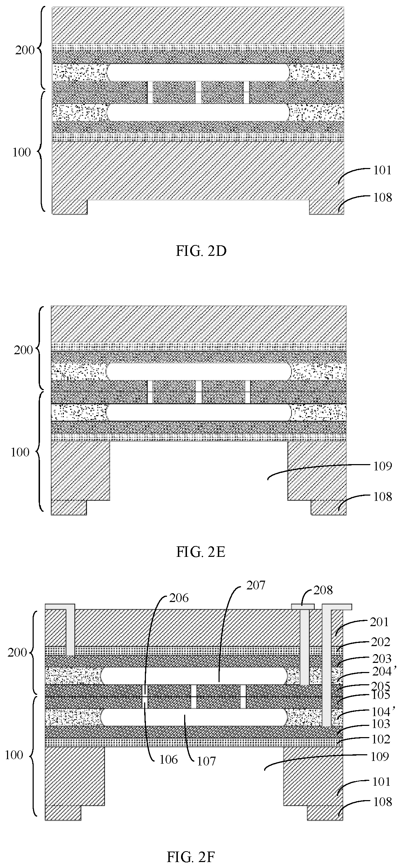

Step S140 is performed. As shown in FIGS. 2D to 2E, a portion of the first substrate 101 corresponding to the first cavity 107 is removed, so that the first sensing layer 103 forms a deformable sensing layer.

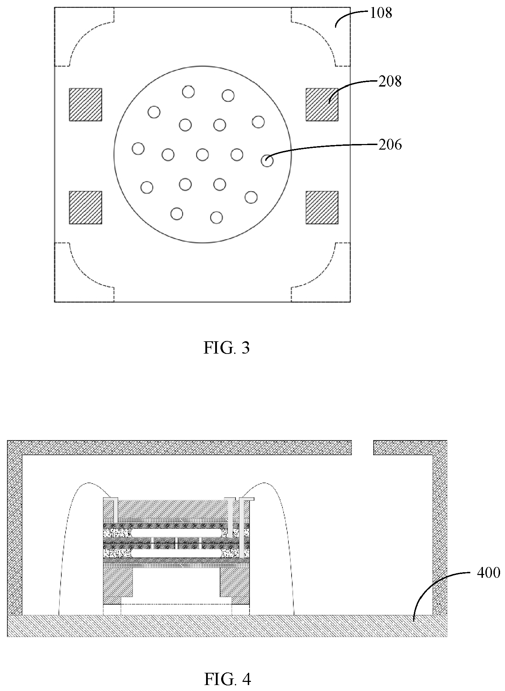

For example, before a portion of the first substrate 101 corresponding to the first cavity 107 is removed, the above method may further include etching the first substrate 101 to form a four-corner support structure 108 at a bottom portion of the first substrate 101. The four-corner support structure 108 includes four support columns (not shown) provided at four corners of the bottom portion of the first substrate 101, and the four support columns are independent of each other. As shown in FIG. 3, the four-corner support structure 108 is configured to fixedly connect the MEMS device to a package substrate.

In an embodiment, as shown in FIG. 2D, a four-corner support structure 108 is formed at the bottom portion of the first substrate 101. Specifically, a patterned mask layer (not shown) is formed on the first substrate 101 through a photolithography process, and then the first substrate 101 is etched to form the four-corner support structure 108. The method for etching the first substrate 101 may use any existing techniques known to those skilled in the art, and in some embodiments, dry etching is used. The dry etching includes but is not limited to reactive ion etching (RIE), ion beam etching, plasma etching, laser ablation, or any combination thereof.

In an embodiment, as shown in FIG. 2E, a portion of the first substrate 101 corresponding to the first cavity 107 is etched to form an opening 109. The method for etching the first substrate 101 may use any existing techniques known to those skilled in the art, and in some embodiments, deep reactive ion etching (DRIE) is used. Specifically, gas silicon hexafluoride (SF6/C₄F₈) is selected as process gas, and a radio frequency power supply is applied, so that the silicon hexafluoride reacts with incoming gas to form high ionization. In the etching step, a working pressure range is controlled to be 20mTorr to 0mTorr, a radio frequency power is 600W, a radio frequency (RF) frequency is 13.5MHz, and a direct current (DC) bias voltage can be continuously controlled in a range of -500V to 1000V to ensure a requirement of anisotropic etching. The deep reactive ion etching system may be a device commonly used in the art and is not limited to a specific specification.

The DRIE stops at the first insulating layer 102 or the first sensing layer 103, so that the first sensing layer 103 forms a deformable sensing layer. The deformable sensing layer and the common sensing layer form a deformable capacitor. Taking the MEMS device serving as a pressure sensor as an example, all the above-mentioned sensing layers are pressure sensing films. When the MRMS pressure sensor operates, the deformable sensing layer is deformed, and the deformable capacitor formed by the deformable sensing layer and the common sensing layer is configured to measure a pressure. The reference capacitor formed by the third sensing layer 203 and the common sensing layer serves as reference. Accordingly, the measurement accuracy of the MEMS device is improved.

As shown in FIG. 2F, the method may further include a step of forming a metal wiring layer 208 on the second substrate 201. The metal wiring layer 208 is connected to the third sensing layer 203, the common sensing layer, and the deformable sensing layer respectively.

In an embodiment, a material of the metal wiring layer 208 is generally aluminum or gold. The metal wiring layer 208 includes metal traces and a PAD structure, and is connected to the third sensing layer, the common sensing layer, and the deformable sensing layer respectively, to output a test signal.

The key steps in the method for manufacturing the MEMS device in the present application has been introduced above. For the manufacturing of the complete device, several other technological processes may be required, and details are not described herein.

It should be noted that a sequence of the above-mentioned steps is merely described as an example. Without conflicting, the above-mentioned steps may be rearranged or alternately performed.

The present application further provides a MEMS device manufactured according to the above method. As shown in FIG. 2F and FIG. 3, the MEMS device includes:
a first substrate 101, on which a first sensing layer 103, a first cavity 107, a common sensing layer, a second cavity 207, a third sensing layer 203, and a second substrate 201 are sequentially formed, where the first substrate 101 includes an opening 109 provided corresponding to the first cavity 107, so that the first sensing layer 103 forms a deformable sensing layer.

In an embodiment, the first substrate 101 may be any appropriate semiconductor substrate, such as a silicon substrate. A four-corner support structure 108 is formed at a bottom portion of the first substrate 101, and is configured to fixedly connect the MEMS device to a package substrate. The first substrate 101 further includes an opening 109 provided corresponding to the first cavity 107. The opening 109 exposes a first insulating layer 102 or the first sensing layer 103, such that the first sensing layer 103 forms a deformable sensing layer, and the deformable sensing layer and the common sensing layer form a deformable capacitor.

In an embodiment, the first insulating layer 102, the first sensing layer 103, the first cavity 107, the common sensing layer, a second cavity 207, a third sensing layer 203, a second insulating layer 202, and a second substrate 201 are sequentially formed on the first substrate 101. Materials of the first insulating layer 102 and the second insulating layer 202 include but are not limited to an oxide layer. The thickness of the first insulating layer 102 and the second insulating layer 202 is generally less than the thickness of the first sensing layer 103 and the third sensing layer 203. Materials of the first sensing layer 103, the common sensing layer, and the third sensing layer 203 include but are not limited to doped polysilicon. Thicknesses of the first sensing layer 103 and the third sensing layer 203 are in a range of 1µm to 5µm, and the thickness of the common sensing layer is greater than the thickness of the first sensing layer 103 and the third sensing layer 203. A first support portion 104' supports and surrounds the first cavity 107, and a second support portion 204' supports and surrounds the second cavity 207. Materials of the first support portion 104' and the second support portion 204' include but are not limited to silicon oxide. The thicknesses of the first support portion 104' and the second support portion 204' may be set according to requirements, and a spacing between the first cavity 107 and the second cavity 207 is controlled by controlling the thicknesses of the first support portion 104' and the second support portion 204', to control a capacitance value between the first sensing layer 103 and the common sensing layer and a capacitance value between the second sensing layer 203 and the common sensing layer.

In an embodiment, a plurality of first through holes 106 formed on the second sensing layer 105 and a plurality of second through holes 206 formed on the fourth sensing layer 205 are in a one-to-one correspondence. After the second sensing layer 105 is bonded with the fourth sensing layer 205 to form the common sensing layer, the plurality of first through holes 106 are communicated with the plurality of second through holes 206 respectively. The first cavity 107 and the second cavity 207 form a common cavity, which keeps a vacuum state or a low-pressure state close to vacuum, for example, an air pressure in the cavity is less than 10Pa.

In an embodiment, the thickness range of the second substrate 201 is 40µm to 50µm. Since the second substrate 201 keeps a relatively large thickness, deformation of the third sensing layer 203 is avoided, and a non-deformation state of the second cavity 207 is ensured. The third sensing layer 203 and the common sensing layer form a reference capacitor. By providing both the deformable capacitor and the reference capacitor in the MEMS device, the sensitivity and anti-interference capability of the MEMS device can be improved.

In an embodiment, a metal wiring layer 208 is further formed on the second substrate 201. The metal wiring layer 208 includes metal traces and a PAD structure, and is connected to the third sensing layer, the common sensing layer, and the deformable sensing layer respectively, to output a test signal.

The present application further provides an electronic device. As shown in FIG. 4, the electronic device includes a package substrate 400 and the above-described MEMS device fixed on the package substrate 400.

In an embodiment, the MEMS device is fixed on the package substrate 400 through the four-corner support structure 108, allows the deformable sensing layer film to face downward during the packaging of the device. As shown in FIG. 4, the problem of surface contamination caused by the deformable sensing layer film facing upward is avoided, the reliability of the MEMS device is improved, and the service life of the MEMS device is prolonged.

In an embodiment, the four-corner support structure 108 of the MEMS device is fixed on the package substrate 400 by a four-corner adhesive bonding method. In a conventional packaging method, glue is applied to the entire bottom portion of the MEMS device or to the periphery of the bottom portion of the MEMS device, and then the bottom portion of the MEMS device is bonded to the substrate 400. Since a contact area between the MEMS device and the package substrate 400 is large, and a thermal expansion coefficient of the MEMS device is different from that of the package substrate 400, a volume deformation caused by an ambient temperature change of the MEMS device in use is also relatively large, and a deformation stress may be transmitted to the interior of the MEMS device, which leads to an error. In the present application, by performing two-step etching on the first substrate 101, a structure in which there are only support columns at the four corners is formed on the bottom portion. As shown in FIG. 3, when packaging the device, bonding is performed only at the four corners, and thus resulted deformation is uniform, which avoids introducing stress, so that the temperature stability is good. The raised hollow structure in the four-corner support structure 108 may form a pressure transmission channel to transmit the pressure to the surface of the deformable sensing film at the center of the bottom portion of the MEMS device.

According to the MEMS device and the method for manufacturing the MEMS device provided in the present application, a stacked double-layer capacitor structure is manufactured in a heterogeneous bonding mode. The process is simple and highly feasible, and the manufactured device structure does not require hole plugging, which avoids the unevenness of the sensing layer caused by hole plugging. It also avoids reliability issues such as air leakage of the hole plugging structure due to the repeated movement of the upper pressure-sensitive film of the sealed cavity during pressure measurement, improving the service life and yield of the device.

The technical features in the above-described embodiments may be combined in any manner. To make the description brief, all possible combinations of the technical features in the embodiments are not described. However, as long as there is no contradiction between the combinations of the technical features, the combinations should be considered as the scope of the present application.

The above-described embodiments merely express several implementation modes of the present application, and the description thereof is relatively specific and detailed, but it should not be construed as limiting the scope of the present application. It should be pointed out that, those skilled in the art can make several transformations and improvements without departing from the concept of the present application, which all fall within the scope of protection of the present application. Therefore, the protection scope of the present application should be subject to the appended claims.

## Claims

1. A method for manufacturing a micro-electro-mechanical system (MEMS) device, comprising:
forming a first MEMS structure, which comprises:
providing a first substrate and forming a first sensing layer on the first substrate; and
forming a first cavity and a second sensing layer sequentially on the first sensing layer;
forming a second MEMS structure, which comprises:
providing a second substrate, forming a third sensing layer on the second substrate and
forming a second cavity and a fourth sensing layer sequentially on the third sensing layer;
bonding the second sensing layer with the fourth sensing layer to form a common sensing layer; and
removing a portion of the first substrate corresponding to the first cavity, and thus the first sensing layer forms a deformable sensing layer.

2. The method for manufacturing the MEMS device according to claim 1, wherein the deformable sensing layer and the common sensing layer form a deformable capacitor, and the common sensing layer and the third sensing layer form a reference capacitor.

3. The method for manufacturing the MEMS device according to claim 1, wherein forming the first cavity on the first sensing layer comprises:
forming a first sacrificial layer and the second sensing layer sequentially on the first sensing layer;
forming a plurality of first through holes on the second sensing layer; and
removing a portion of the first sacrificial layer through the plurality of first through holes to form the first cavity.

4. The method for manufacturing the MEMS device according to claim 3, wherein a plurality of second through holes are formed on the fourth sensing layer, the plurality of first through holes and the plurality of second through holes are in a one-to-one correspondence, and the plurality of first through holes are communicated with the plurality of second through holes respectively after the second sensing layer is bonded with the fourth sensing layer, such that the first cavity and the second cavity form a common cavity.

5. The method for manufacturing the MEMS device according to claim 1, further comprising thinning the second substrate such that a thickness of the second substrate is within a range of 40µm to 50µm.

6. The method for manufacturing the MEMS device according to claim 1, wherein thicknesses of the first sensing layer, the second sensing layer, the third sensing layer, and the fourth sensing layer are in a range of 1µm to 5µm, and the first sensing layer, the second sensing layer, the third sensing layer, and the fourth sensing layer include doped polysilicon layers.

7. The method for manufacturing the MEMS device according to claim 1, wherein before removing the portion of the first substrate corresponding to the first cavity, the method further comprising:
etching the first substrate to form a four-corner support structure at a bottom portion of the first substrate, wherein the four-corner support structure is configured to fixedly connect the MEMS device to a package substrate.

8. The method for manufacturing the MEMS device according to claim 5, further comprising forming a metal wiring layer on the second substrate, wherein the metal wiring layer is connected to the third sensing layer, the common sensing layer, and the deformable sensing layer respectively.

9. The method for manufacturing the MEMS device according to claim 3, wherein forming the plurality of first through holes on the second sensing layer comprises:
forming a patterned mask layer on the second sensing layer through a photolithography process, and etching the second sensing layer to form the plurality of first through holes.

10. The method for manufacturing the MEMS device according to claim 1, wherein forming the second cavity on the third sensing layer comprises:
forming a second sacrificial layer and the fourth sensing layer sequentially on the third sensing layer, forming a plurality of second through holes on the fourth sensing layer, and removing a portion of the second sacrificial layer through the plurality of second through holes to form the second cavity.

11. A MEMS device manufactured according to the method of any one of claims 1 to 10, the MEMS device comprising:
a first substrate on which a first sensing layer, a first cavity, a common sensing layer, a second cavity, a third sensing layer, and a second substrate are sequentially formed, wherein the first substrate comprises an opening provided corresponding to the first cavity, such that the first sensing layer forms a deformable sensing layer.

12. The MEMS device according to claim 11, further comprising a pressure sensor, wherein the sensing layers comprise pressure sensing films.

13. The MEMS device according to claim 11, wherein a four-corner support structure is formed at a bottom portion of the first substrate, and is configured to fixedly connect the MEMS device to a package substrate.

14. The MEMS device according to claim 11, wherein a metal wiring layer is further formed on the second substrate, the metal wiring layer comprises metal traces and is connected to the third sensing layer, the common sensing layer, and the deformable sensing layer respectively.
